# EUROPEAN PATENT SPECIFICATION

(11) **EP 2 297 590 B1**
(45) Date of publication and mention of the grant of the patent: **21.03.2012**
(21) Application number: 09757871.0
(22) Date of filing: 03.06.2009
(51) Int. Cl.: G01R 31/28, G01R 31/319, G01R 1/04

(54) **TEST OF ELECTRONIC DEVICES WITH BOARDS WITHOUT SOCKETS BASED ON MAGNETIC LOCKING**
PRÜFUNG ELEKTRONISCHER ANORDNUNGEN MIT LEITERPLATTEN OHNE SOCKEL AUF DER BASIS MAGNETISCHER VERRIEGELUNG
TEST DE DISPOSITIFS ELECTRONIQUES AU MOYEN DE CARTES SANS DOUILLES A VERROUILLAGE MAGNETIQUE

(30) Priority: 04.06.2008 IT MI20081023
(43) Date of publication of application: 23.03.2011
(73) Proprietor: Eles Semiconductor Equipment S.P.A., 06059 Todi (Perugia) (IT)
(72) Inventor: SCOCCHETTI, Fabrizio, I-06059 Todi (PG) (IT)
(74) Representative: Pezzoli, Ennio
(86) International application number: PCT/IB2009/005875
(87) International publication number: WO 2009/147517

(56) References cited:
- EP-A1- 1 959 262
- WO-A1-2008/098987
- US-A- 3 596 228
- US-A1- 2005 030 007

## Description

The solution according to an embodiment of the present invention relates to the field of test. More specifically, such solution relates to the test of electronic devices.

The electronic devices (typically including one or more integrated circuits) are generally subject to a test process in order to verify their correct operation; this is of the utmost importance in order to ensure a high quality of a production process of the electronic devices. The test can be aimed at identifying defects that are evident or potential (that is, that could occur after a short period of use). At the same time, the integrated circuits under test can be conditioned thermally (so as to ensure that they work at a predetermined temperature). A typical example is the burn-in test, which consists of making the electronic devices work for some hours at temperature being very high or very low (for example, from -50°C to +150°C); in this way, it is possible to simulate a long period of operation of the same electronic devices at room temperature (that is, 25°C-50°C).

The test can be carried out at wafer level or at package level. In the first case, the integrated circuits are tested directly - when they are still included in a wafer of semiconductor material; on the other hand, in the second case the electronic devices are tested after their production is complete (that is, the integrated circuits have been cut and enclosed in suitable packages). The test at package level reduces the risks of damaging of the integrated circuits (for example, due to atmospheric contaminations or hits); moreover, this allows testing the electronic devices in their actual final form.

The test of the electronic devices at package level requires that they should be mounted on test boards, which are used for interfacing the electronic devices with a test apparatus. For this purpose, each test board is equipped with corresponding sockets. The sockets mechanically lock the electronic devices and electrically connect them to the test apparatus; at the same time, the sockets allow removing the electronic devices without any substantial damage at the end of the test process. Typically, each socket is formed by a base that is equipped with elements for electrically contacting the corresponding electronic device; the base is closed by a cover (for example, being hinged to it), so as to completely enclose the electronic device. In the particular case of test of the thermal type (such as the above-mentioned burn-in test), the test apparatus is also equipped with a system for controlling the temperature of the electronic devices. In general terms, such result is obtained by forcing warm or cold air towards the test boards.

However, the structure of the known test boards is relatively complex. In particular, the assembly of the sockets on the test boards requires various dedicated operations; for example, the sockets are welded on the test boards or are clip-mounted thereon. This has a negative impact on the cost of the test boards, and therefore of the whole test process.

Moreover, the control of the temperature of the electronic devices is not completely effective. In particular, it is very difficult (if not impossible) to obtain a uniform distribution of the temperature among the various electronic devices.

At the end, the test processes known in the art require that the electronic devices should be mounted on the boards in a dedicated assembling station. The test boards are then transported to the test apparatus in order to test the electronic devices being mounted on the test boards. At the end of the test process, the test boards are returned to the assembling station for the removal of the tested electronic devices. It is now possible to insert the electronic devices that have passed the test into trays that will be used for their final shipping. However, the above-described operations (and in particularly the need of assembling/de-assembling the test boards and moving them to and from the test apparatus) add further complexity and increase the duration of the test process.

All of the above maintains the cost of the test process relatively high; this drawback limits the diffusion of the test process, and consequently reduces the level of quality and reliability in the production of the electronic devices.

Moreover, US-A-3596228 discloses a contactor having a flexible dielectric membrane with electrically conductive lines for contacting a chip: the membrane is mounted on a pressure chamber and a pressurized fluid is used to move the membrane including its lines into contact with the chip.

US-A-2005/0300007 discloses a pusher with a balloon receiving a fluid therein; the pressure inside the balloon causes the balloon to press a semiconductor device towards a socket (thereby allowing electrodes of the device to contact corresponding pins of the socket).

EP-A-1959262 and WO-A-2008/098987 (published after the filing date of the present application but with an earlier priority date) disclose a test equipment with a variable-volume chamber for a conditioning fluid flowing throught it; the chamber (when expanded) presses an electronic device rested on a test board towards it (to provide its electrical connection and mechanical locking), and at the same time warms or cools the device.

In its general terms, the solution according to an embodiment of the present invention is based on the idea of removing the sockets from the test boards.

In particular, various aspects of the solution according to an embodiment of the invention are set out in the independent claims. Advantageous characteristics of the same solution are indicated in the dependent claims.

More specifically, an aspect of the solution according to an embodiment of the invention proposes a test apparatus for testing electronic devices; each electronic device has a plurality of terminals for electrically contacting the electronic device. The test apparatus includes a set of test boards; each test board is equipped with a plurality of banks of electrically conductive receptacles, each one for resting a corresponding electronic device (with each receptacle that it is adapted to receive a terminal of the corresponding electronic device). Locking means are provided for mechanically locking the electronic devices on the test boards. The locking means include free means - such as ferromagnetic discs - adapted to be freely rested on the electronic devices in order to press the electronic devices against the test boards - for example, because of the attractive force exerted by corresponding magnetic discs being fastened under the test board.

A further aspect of the solution according to an embodiment of the invention proposes a test board for use in the test system.

Another aspect of the solution according to an embodiment of the invention proposes a test apparatus including such test system.

A still further aspect of the solution according to an embodiment of the invention proposes a corresponding test process.

A different aspect of the solution according to an embodiment of the invention proposes a production process of the test board.

The same solution, as well as further features and the advantages thereof, will be best understood with reference to the following detailed description, given purely by way of a non-restrictive indication, to be read in conjunction with the accompanying drawings. In this respect, it is expressly intended that the figures are not necessary drawn to scale and that, unless otherwise indicated, they are merely used to conceptually illustrate the structures and procedures described herein. In particular:
FIGs.1A-1B illustrate an example of application of the solution according to an embodiment of the invention,
FIG.2 is a schematic representation of a test apparatus wherein the solution according to an embodiment of the invention can be used,
FIGs.3A-3F show the various steps of a process that can be used for producing a test board according to an embodiment of the invention,
FIGs.4B-4A illustrate an application of the solution according to an embodiment of the invention to a different type of electronic devices, and
FIGs.5A-5F show the various steps of a process that can be used for producing a test board according to another embodiment of the invention.

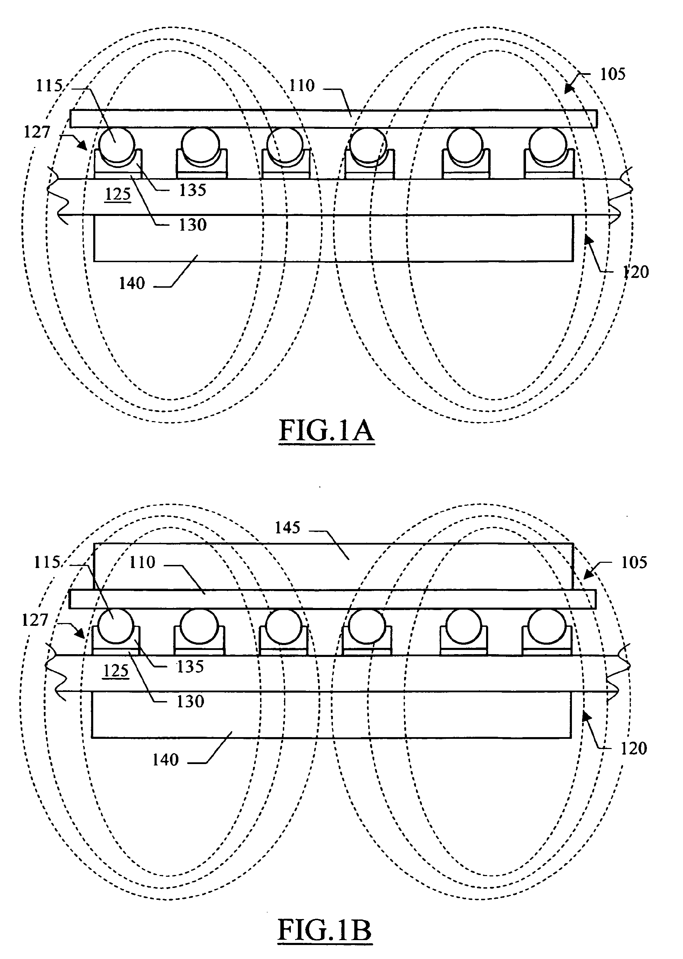

With reference in particular to FIGs.1A-1B, there is illustrated an example of application of the solution according to an embodiment of the invention.

Starting from FIG.1A, a generic electronic device to be tested is indicated with the reference 105; for example, the electronic device 105 is subject to a burn-in test (wherein the electronic device 105 is tested under thermal stress). The electronic device 105 is provided at the package level (that is, in its final form); more in detail, the electronic device 105 includes an integrated circuit that is made in a chip of semiconductor material (not shown in the figure); the chip is enclosed in a case 110 made up of an insulating body (for example, of plastic material). The chip is electrically connected to external terminals 115 of the electronic device 105, which implement input/output (I/O) functions of the integrated circuit. In the example at issue, the electronic device 105 is of the Ball Grid Array (BGA) type, wherein the terminals 115 consist of a matrix of small spheres protruding from a lower surface of the case 110.

During a test process, a set of electronic devices 105 (only one shown in figure) is placed on a test board 120 - consisting of a Burn-In Board, or BIB, in the example at issue. The test board 120 is formed by a circuited insulating substrate 125 (for example, a printed circuit board with one or more layers of conductive tracks). The test board 120 includes a set of housings 127 (only one shown in the figure), each one of them is adapted to receive a corresponding electronic device 105 to be tested; for example, the test board 120 is equipped with a matrix of housings 127 with 2-10 rows and 5-20 columns. Each housing 127 consists of a bank of conductive elements for electrically contacting the terminals 115 of the electronic device 105; for example, each conductive element includes an (electrically conductive) pad 130 on which an (electrically conductive) receptacle is formed 135 - with the conductive elements 130,135 that are arranged in compliance with the terminals 115 (that is, in a matrix in the case at issue of electronic device 105 of the BGA type). The pads 130 are formed on an upper surface of the substrate 125, and are electrically connected to the tracks of the substrate 125 for distributing the required electric signals during the test process. The electronic device 105 is simply rested on the test board 120, and in particular on the corresponding receptacles 135 that receive the terminals 115 of the electronic device 105 (without any mechanical locking). An interaction disc 140 is fastened on a lower surface of the test board 120 (below the housing 127); for example, the disc 140 is made of magnetic material (such as magnetite). The disc 140 is arranged so that the corresponding magnetic moment is transversal to the test board 120 (for example, with its north pole on a base of the disc 140 facing the substrate 125, and its south pole on the other base thereof); in such way, a magnetic field generated by the disc 140 (indicated schematically by dotted lines in the figure) completely encloses the electronic device 105 rested on the receptacles 135.

As shown in FIG.1B, a free disc 145 is then rested on the electronic device 105 - that is, on a rear surface of the case 110 being devoid of terminals; for example, the disc 145 is made of ferromagnetic material (such as steel). The disc 145 is thus placed inside the magnetic field generated by the disc 140. Therefore, the disc 145 magnetizes (with the south pole on its lower surface and the north pole on its upper surface in the example at issue); consequently, a magnetic attractive force is generated between the discs 140 and 145. Such attractive force depends on the strength of the magnetic field being provided by the disc 140 (in turn depending on magnetic features of the material of the disc 140 and on its size/shape), and on the distance between the discs 140-145. Typically, the attractive force has a value of the order of 0,01-0,05 N. In such way, the disc 145 presses the electronic device 105 against the test board 120, and in particular the terminals 115 in the corresponding receptacles 135. Consequently, the electronic device 105 is mechanically locked on the test board 120; at the same time, this ensures a correct electrical connection between the terminals 115 and the receptacles 135.

At the end of the test process, the disc 145 is raised (overcoming the attractive force being exerted by the disc 140). Consequently, the electronic device 105 is freed. This allows removing the electronic device 105 from the test board 120 without any damage.

The proposed solution remarkably simplifies the structure of the test boards 120, since they are devoid of any socket for the mechanical locking of the electronic devices 105; therefore, it is possible to reduce the number of operations required for the production of the test boards 120 (without the ones being necessary for the assembly of the sockets). This has a positive effect on the cost of the test boards 120, and therefore of the whole test process.

The above-mentioned advantages foster the diffusion of the test process, with positive falling back on the quality and on the reliability of the production of the electronic devices 105.

In the particular case of test of the thermal type (such as the burn-in test at issue), warm or cold air is forced towards the test boards 120 for thermally conditioning (that is, heating or cooling, respectively) the electronic devices 105 under test. In such case, however, each electronic device 105 is only surmounted by the disc 145 but it is completely free at its sides. Therefore, the cold/warm air acts directly on the electronic device 105 (which is not enclosed in any socket). This allows controlling the temperature of the electronic devices 105 in a more effective way. In particular, the direct action of the cold/warm air on the electronic devices 105 makes it possible to obtain a substantially uniform distribution of the temperature among them.

The above-described specific embodiment of the proposed solution offers further advantages.

In particular, the use of a distinct disc 145 for each housing 127 allows pressing each electronic device 105 against the test board 120 independently (so as to improve the electrical connection between the terminals 115 and the receptacles 135).

The exploitation of the magnetic interaction between the discs 140 and 145 generates an attractive force sufficiently high (for firmly locking the electronic devices 105 on the test board 120); at the same time, however, the discs 145 can be maintained light and thus manageable.

The arrangement of the discs 140 (fastened under the test board 120) does not introduce substantial complications in their production (guaranteeing however the demanded magnetic interaction with the discs 145 through the substrate 125).

The choice of making only the discs 140 (fastened under the test board 120) of magnetic material makes the discs 145 (in ferromagnetic material) easier to handle during the test process.

Moreover, the provision of a distinct disc 140 for each housing 127 reduces the use of magnetic material as low as possible (that is, only where actually necessary in order to interact with the corresponding dises 145).

The proposed extension of the discs 140 and of the discs 145 (substantially equal to that of the corresponding housings 127) further allows obtaining a uniform distribution of the pressure exerted on the electronic devices 105.

In the case at issue, the receptacles 135 are concave-shaped; moreover, the receptacles 135 are preferably resilient (that is, they elastically deform under the pressure exerted by the electronic device 105). Consequently, it is possible to obtain a self centring of the (convex) terminals 115 in the receptacles 135. This facilitates the positioning of the electronic devices 105 on the test board 120; moreover, it is possible to prevent any misalignment of the electronic devices 105 with respect to the test board 120 (for example, during its movement).

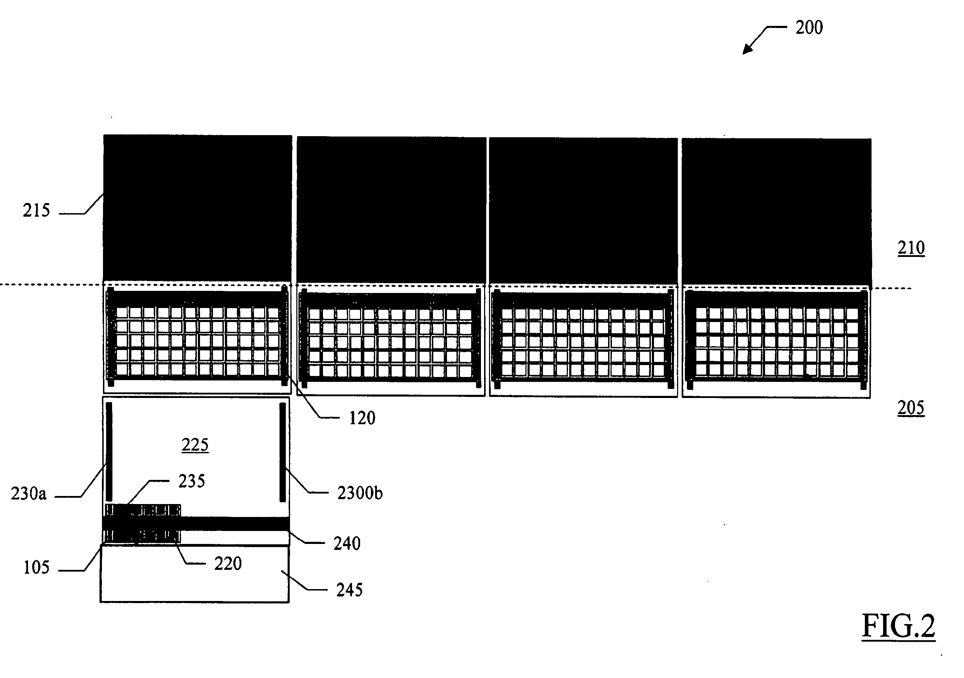

Considering now FIG.2, it is shown a schematic representation of a test apparatus 200 that can be used for implementing the solution according to an embodiment of the invention

The test apparatus 200 includes a conditioning area 205, which is used for controlling the temperature of the electronic devices 105 being mounted on the test boards 120. The test apparatus 200 is further equipped with a control zone 210, which is maintained at room temperature; the control zone 210 is thermally insulated from the conditioning zone 205, with the two zones 205 and 210 that communicate through slots provided with protecting seals (not shown in the figure). The control zone 210 houses a plurality of driving boards 215. Each test board 120 (once inserted in the conditioning zone 205) is electrically connected to a corresponding driving board 215. The driving board 215 includes the circuits that are used for controlling the test process of the electronic devices 105 being placed on the test board 120; for example, the driving board 215 provides a power supply and stimulus signals to the electronic devices 105, and receives corresponding result signals therefrom.

The electronic devices 105 to be tested are provided in a tray 220 (which will be used for their final shipping). The tray 220 with these electronic devices 105 is transported towards a loader 225, which is placed in front of a (current) test board 120. This test board 120 is extracted from the conditioning zone 205; in particular, the test board 120 is disengaged from the corresponding driving board 215 and is made to slide on a pair of tracks 230a and 230b of the loader 225. A head 235 of the loader 225 (for example, of the vacuum type) picks up a (current) electronic device 105 from the tray 220. The head 235 is mounted on a bar 240, which slides towards the test board 120 till reaching the row of a target housing (for the electronic device 105). The head 235 then slides along the bar 240 till reaching the column of the target housing. At this point, the head 235 releases the electronic device 105 so as to rest it on the target housing The loader 225 is also equipped with a reservoir 245 for the magnetic disks (not shown in the figure). The head 235 picks up a magnetic disk from the reservoir 245. As above, the bar 240 slides towards the test board 120 till reaching the row of the same target housing, and then the head 235 slides along the bar 240 till reaching the column of the target housing. At this point, the head 235 releases the magnetic disk on the electronic device 105 placed on the target housing (so as to mechanically lock it thereon).

The same above-described operations are repeated until the test board has been filled in. The test board is then re-inserted into the conditioning zone 205, with the electronic devices that are placed on them and locked by the magnetic discs, so as to return to its original position (coupled with the corresponding driving board 215). The loader 225 is moved in front of a next test board 120, so as to reiterate the same operations (until all the electronic devices have been loaded in the test apparatus 200).

At the end of the test process, the above-describe operations are repeated in reverse order. In particular, a (current) test board 120 is picked up from the conditioning zone 205 making it slide on the tracks 230a and 230b of the loader 225 (placed in front of it). The head 235 is moved above each housing of the test board 120 (making the bar 240 slide towards its row and then making the head 235 slide along the bar 240 until reaching its column). The head 235 picks up the magnetic disc rested on the electronic device 105 placed in such housing and returns it to the reservoir 245, where the magnetic disc is released. The head 235 is again moved above the same housing; the head 235 now picks up the (free) electronic device 105 and returns towards a position of the tray 220 being not taken up, where the electronic device 105 is released. The same above-described operations are repeated until emptying the test board 120. The test board 120 is then returned to the conditioning zone 205. The loader 225 is moved in front of a next test board 120, so as to reiterate the same operations (until all the tested electronic devices have been returned to the tray 220).

In such way, during the whole test process, the electronic devices 105 can be moved by means of the same trays 220 that will be used for their final shipping (with the loader 225 that is integrated in the test system 200, without the need of any external assembling station). This further simplifies and reduces the duration of the test process.

In any case, the same solution can also be used in a classic test apparatus (not shown in figure). In fact, nothing prevents providing a dedicated assembling station, wherein the electronic devices are rested on the test boards and then mechanically locked by means of the magnetic disks. The test boards are then transported to the test apparatus for testing the electronic devices (mounted on them). At the end of the test process, the test boards are returned to the assembling station for the removal of the magnetic disks and then of the tested electronic devices (with the electronic devices that have passed the test that are then inserted into the trays for their final shipping).

In such way, it is possible to exploit the advantages provided by the proposed solution also in pre-existing tests systems (without requiring any substantial modification of the test processes already in use).

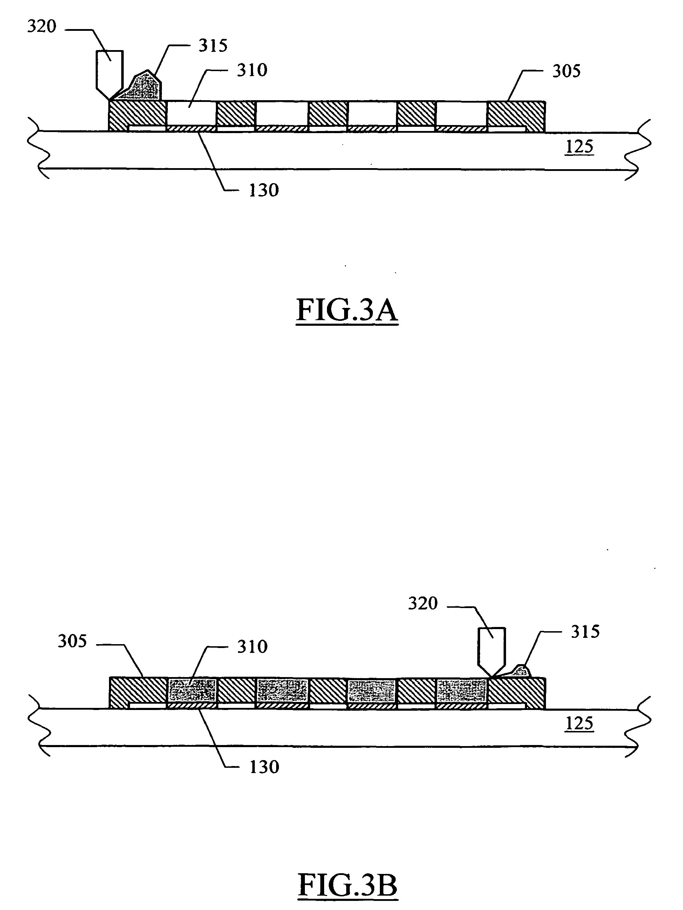

The various steps of a process that can be used for producing the test board according to an embodiment of the invention are shown in FIGs.3A-3F.

Considering in particular FIG.3A, the process begins by providing the substrate 125; the pads 130 are formed on the upper surface of the substrate 125 - in the positions corresponding to the terminals of the electronic devices to be tested - by conventional photo-lithographic techniques (for example, depositing an aluminium layer that is then selectively etched).

A precursor material of the receptacles is distributed on the pads 130 by a silk-screening technique. For such purpose, a stencil 305 is placed on the substrate 125. The stencil 305 includes a matrix of windows 310 corresponding to the pads 130. A polymer 315 is then applied on the pads 130 - through the stencil 305 - by a blade 320; the polymer 315 consists of a material that is electrically conductive and deformable (for example, the commercial product " Loctite 3880" distributed by Loctite Corp.).

As shown in FIG.3B, this result is obtained by making the blade 320 cross the whole stencil 305; in such way, the polymer 315 is pushed inside the windows 310.

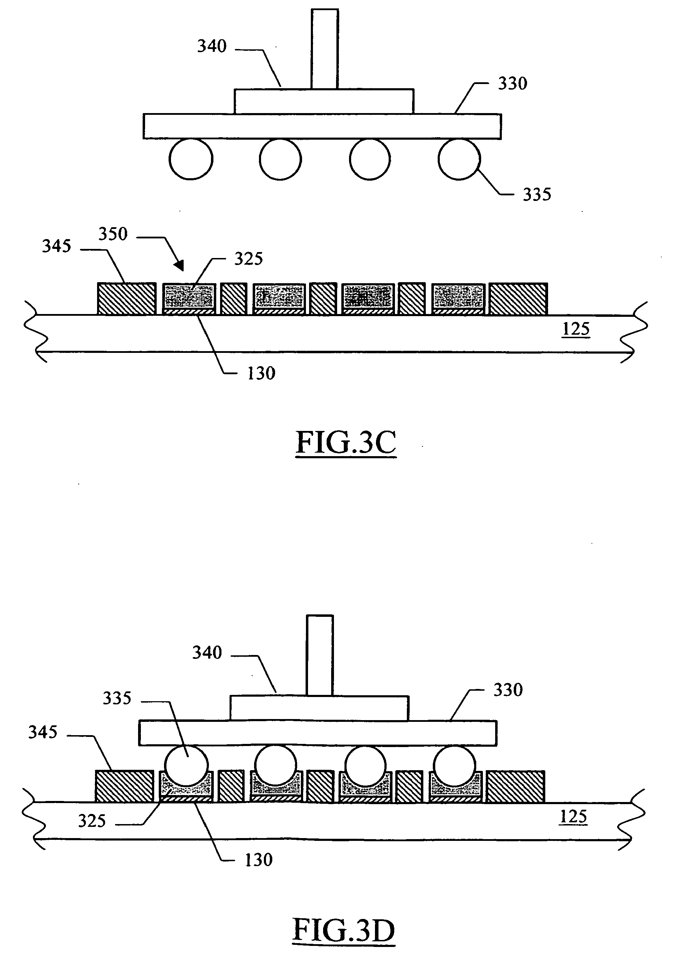

Moving to FIG.3C, when the stencil is removed a polymer island 325 remains on each pad 130. The islands 325 are then shaped - according to the terminals of the electronic devices to be tested - by a forming tool 330. For such purpose, a bottom surface of the forming tool 330 is equipped with a matrix of dummy elements 335 that mimic the terminals of one or more electronic devices; the forming tool 330 may consist of a dummy component or of one or more samples of the electronic devices. The forming tool 330 is mounted on a pick and place head 340; the head 340 is controlled by an optical system, such as a laser or infrared system (not shown in figure), which allows correctly aligning the dummy elements 335 with the islands 325.

Preferably, a restraining stencil 345 is further arranged on the substrate 125. The stencil 345 includes a matrix of windows 350 corresponding to the islands 325. Each window 350 has the same shape of the corresponding islands 325, but it is slightly wider. In this way, an empty channel is formed around the island 325 (between it and the stencil 345); for example, this channel has a width that vary preferably between 50µm - 250µm, and more preferably between 100µm - 200µm, such as 150µm.

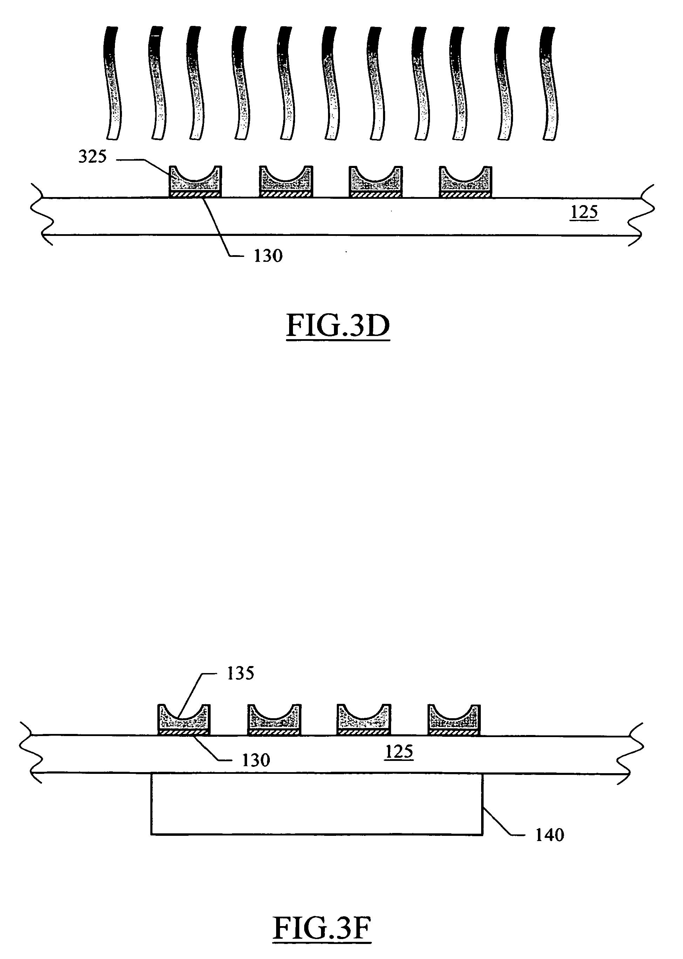

At this point, the head 340 is lowered so as to press the forming tool 330 against the substrate 125 (see FIG.3D). Consequently, the dummy elements 335 act as a mould that deforms the islands 325 accordingly; the islands 325 are then shaped like a negative of the dummy elements 335 (and then of the terminals of the electronic devices). The same operation is repeated (if necessary) till shaping all the islands 325 of the test board.

In this phase, the pressure that is exerted by each dummy element 335 on the corresponding island 325 can also widen it. However, at the most the island 325 can expand of the width of the channel that is formed around it by the stencil 345. In this way, the stencil 345 limits the extension of the widening of the islands 325. This prevents the adjacent islands 325 entering in contact (thereby creating short circuits that would impair the operation of the resulting test board). Moreover, in this way it is possible to use any wished material in order to form the islands 325 (for example, with a higher conductivity), even if it is too much fluid.

Moving to FIG.3E, the head is raised and the forming tool is removed (with the restraining stencil, if present). The structure thus obtained is now inserted into a furnace (for example, at 125-200°C for 10-30 min.), so as to polymerize the material that forms the (shaped) islands 325.

In this way, as shown in FIG.3F, the islands are hardened to form the wished receptacles 135. At this point the disc 140 is fastened under the substrate 125; for example, such result can be obtained with welding techniques, gluing techniques, and the like.

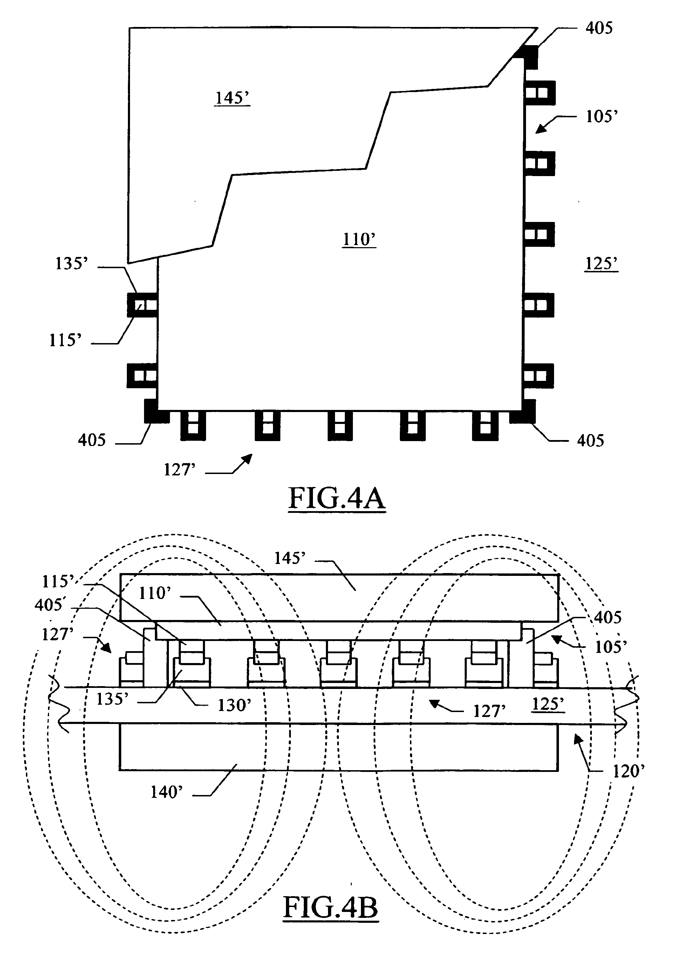

The application of the solution according to an embodiment of the invention to a different type of electronic devices is illustrated in FIGs.4A-4B (in the following, the elements corresponding to those shown in the previous figures will be differentiated with an apex). In particular, the figures show a generic electronic device 105' of the Quad Flat Package (QFP) type. In this case, the electronic device 105' has a case 110' with terminals 115' that extend from each one of its four edges; the terminals 115' are of the gull wing type (that is, consisting of conductors that extend horizontally, are folded downwards and then towards the outside so as to define a plane contact for the surface assembly of the electronic device 105').

A test board 120' is again formed by a circuited insulating substrate 125' with a housing 127' for each electronic device 105' to be tested. The housing 127' consists of a bank of conductive elements for electrically contacting the terminals 115' of the electronic device 105'; each conductive element includes a pad 130' on which a receptacle 135' is formed for receiving the corresponding terminal 115'. In this case, each receptacle 135' includes a print matching the plane contact of the terminal 115'. Preferably, four centring turrets 405 are further formed on the upper surface of the substrate 125'. The centring turrets 405 are higher than the receptacles 135', so as to reach the case 110' (when the terminals 115' are rested on the receptacles 135'). The centring turrets 405 are arranged at the four corners of the case 110'; each centring turret 405 has an inner depression for receiving a corresponding edge of the case 110'. The centring turrets 405 facilitate the positioning of the electronic device 105' on the test board 120' and they prevent any misalignment between them (also in this case wherein the terminals 115' are not self-centring). A disc 140' (of magnetic material) is fastened on the test board 120' under the housing 127'.

As above, the electronic device 105' is freely rested on the test boards 120' (with the terminals 115' that are received by the corresponding receptacles 135'). A disc 145' (of ferromagnetic material) is then rested on the electronic device 105'. The magnetic attractive force being generated between the discs 140' and 145' presses the electronic device 105' against the test board 120' (so as to mechanically lock the electronic device 105' on the test board 120' and to ensure the correct electrical connection between the terminals 115' and the receptacles 135'). Moreover, the case 110' interferes with the centring turrets 405, which maintain the electronic device 105' in the wished position. At the end of the test process, the disc 145' is raised, so as to free the electronic device 105' that can be removed.

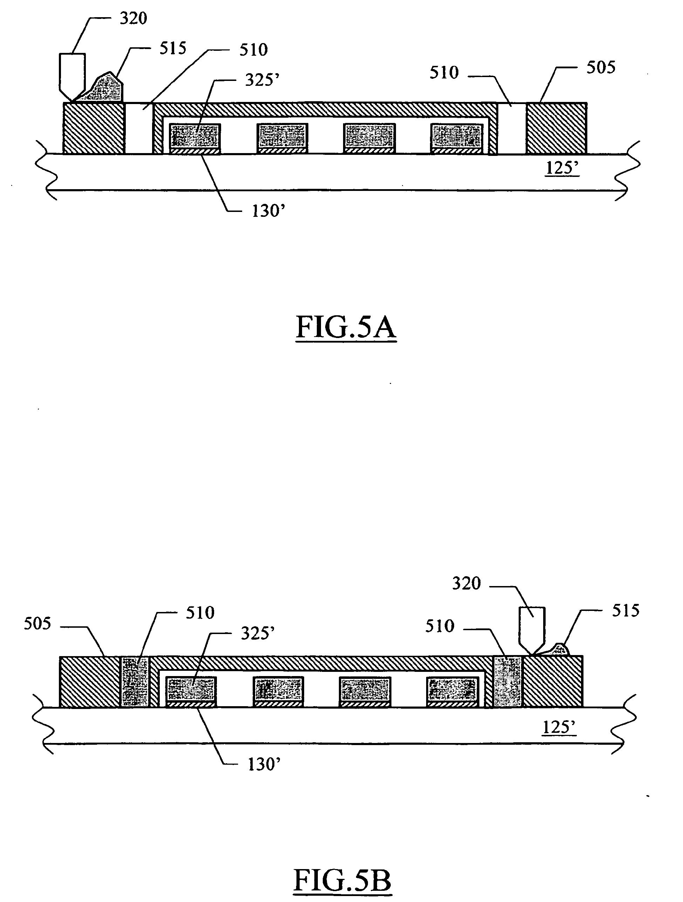

The various steps of a process that can be used for producing the above-described test board are illustrated in FIGs.5A-5F.

Considering in particular FIG.5A, the same operations previously described are repeated in order to form the pads 130' on the upper surface of the substrate 125', and then the islands 325' on the pads 130'. A further silk-screening operation is executed for distributing a precursor material of the centring turrets on the substrate 125'. For such purpose, a stencil 505 is placed on the substrate 125'. The stencil 505 is thicker than that used for creating the islands 325', and it is equipped with legs for spacing it apart from the islands 325' (so as to avoid their damaging); the stencil 505 includes four windows 510 at the edges of the matrix of the pads 130' (only two shown in the figure). A polymer 515 is then applied on the substrate 125' - through the stencil 505 - by the blade 320; the polymer 515 consists of a conductive or insulating deformable material (for example, the same one used to form the islands 325').

As above, see FIG.5B, this result is obtained by making the blade 320 cross the whole stencil 505; in such way, the polymer 515 is pushed inside the windows 510.

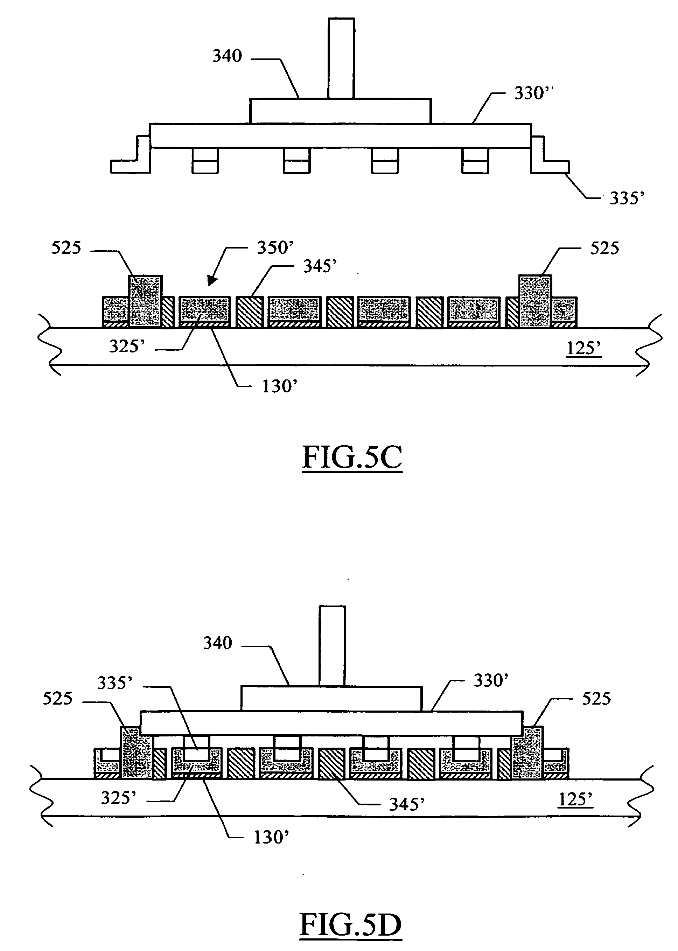

Moving to FIG.5C, when the stencil is removed four columns 525 of polymer (only two shown in figure) remain on the substrate 125'. The islands 325' and the columns 525 are then shaped - according to the electronic devices to be tested - by a forming tool 330'. The forming tool 330' has a main body corresponding to the case of an electronic device (or more); dummy elements 335' extend from each one of the four edges of the main body of the forming tool 330', so as to mimic the terminals of the electronic devices. The forming tool 330' is mounted on the same head 340 as above. Also in this case, a restraining stencil 345' (with windows 350' being slightly wider than the islands 325') can be placed on the substrate 125'.

At this point, the head 340 is lowered so as to press the forming tool 330' against the substrate 125' (see FIG.5D). Consequently, the dummy elements 335' act like a mould that deforms the islands 325' accordingly (shaping them like negative of the dummy elements 335' and then of the terminals of the electronic devices); as above, the stencil 345' limits the widening of the islands 325'. At the same time, each edge of the main body of the forming tool 330' prints an inner portion of the corresponding column 525.

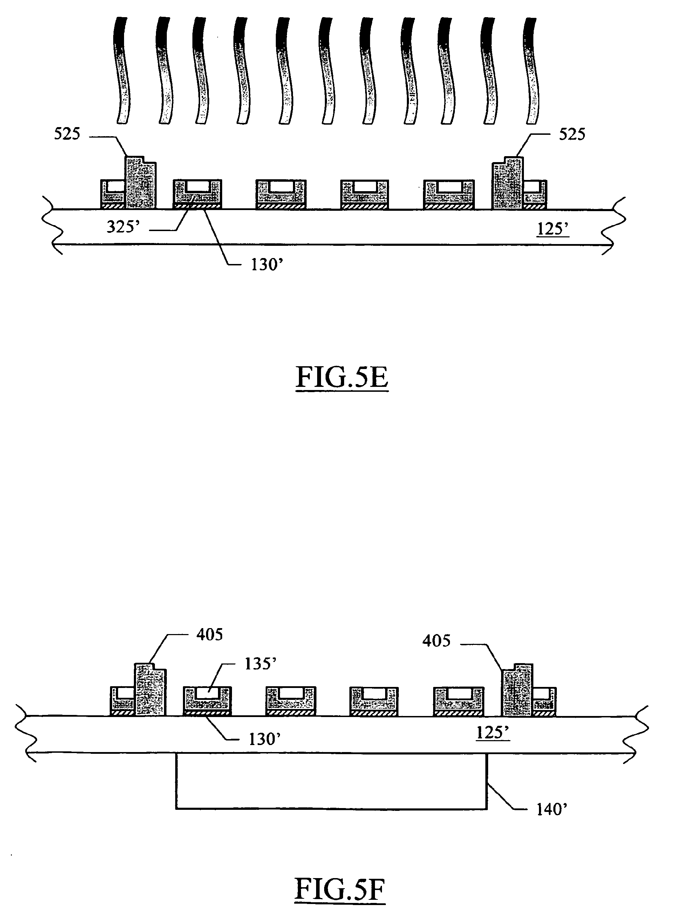

Moving to FIG.5E, the head is raised and the forming tool is removed (with the restraining stencil, if present). The structure thus obtained is again inserted into a furnace, so as to polymerize the material that form the (shaped) islands 325' and columns 525.

In this way, as shown in FIG.5F, the islands and the columns are hardened to form the desired receptacles 135' and centring turrets 405, respectively. At this point, the disc 140' is fastened under the substrate 125'.

Naturally, in order to satisfy local and specific requirements, a person skilled in the art may apply to the solution described above many logical and/or physical modifications and alterations. More specifically, although this solution has been described with a certain degree of particularity with reference to preferred embodiment(s) thereof, it should be understood that various omissions, substitutions and changes in the form and details as well as other embodiments are possible. Particularly, the same solution may even be practiced without the specific details (such as the numerical examples) set forth in the preceding description to provide a more thorough understanding thereof; conversely, well-known features may have been omitted or simplified in order not to obscure the description with unnecessary particulars. Moreover, it is expressly intended that specific elements and/or method steps described in connection with any embodiment of the disclosed solution may be incorporated in any other embodiment as a matter of general design choice.

In particular, analogous considerations apply if the above-described test system (made up of one or more test boards with the corresponding discs) has a different structure or includes equivalent elements. More generally, the same test system can be used in any test process in the widest meaning of the term (also being not of the thermal type); for example, it is possible to use such solution in reliability tests during a preliminary phase of development of the electronic devices (in order to verify small series of electronic devices, down to those being housed on a single test board); other examples are functional tests or parametric tests (that may also be executed at the same time of the burn-in test). Moreover, as previously described, it is possible to test the electronic devices under electrical and/or thermal stress conditions (for example, forcing specific thermal cycles); alternatively, it is possible to simply maintain the temperature of the electronic devices under test at a predetermined value (for example, at room temperature). Moreover, the proposed solution lends itself to be applied to any type of electronic devices (for example, of optical type, based on discreet components, and so on). Moreover, the electronic devices can be provided in different packages (for example, of the Dual-In-Linen type), or can have equivalent terminals (for example, of the J-shaped type).

In any case, the possibility of using a single ferromagnetic disc for two or more electronic devices (up to for all those rested on or more test boards) is not excluded in principle.

Analogous considerations apply if the discs are made of equivalent materials - for example, natural magnets of cobalt or nickel, ceramic magnets, sintered magnets, printed magnets, and the like (for what concerns the magnetic discs), or iron, cobalt, nickel, transition metals, and the like (for what concerns the ferromagnetic discs). In any case, the use of the magnetic interaction for locking the electronic devices on the test board does not have to be interpreted in a limitative Way; for example, a simplified variation of the proposed solution can be implemented simply with discs of any material that maintain locked the electronic devices by means of their own weight.

Moreover, nothing prevents embedding the magnetic discs inside the substrate of the test board, or fastening them on the upper surface of the substrate (with the receptacles that are then made thereon).

In alternative, both discs (both the one fastened on the test board and the free one) can be made of magnetic material, or it is possible to use electromagnets on the test board.

Naturally, the possibility of fastening the ferromagnetic discs on the test board and placing the magnetic disks on the electronic devices falls within the scope of the proposed solution.

Analogous considerations apply if the magnetic disks and/or the ferromagnetic discs have a different extension (both lower and higher than that of the corresponding housings), or have another shape (for example, square or rectangular).

The proposed solution lends itself to be implemented with equivalents receptacles for receiving the terminals of the electronic devices (also simple pads), made of any other material (also being not elastic).

Each electronic device can be aligned with respect to the corresponding receptacle by one or more equivalent centring elements (for example, a frame). Moreover, nothing prevents applying the same solution also to the test board with the concave receptacles; vice-versa, the removal of the centring turrets from the test board with the plane receptacles is contemplated.

Naturally, the test board can have a different structure, it can include equivalent elements, or it can house any number of electronic devices to be tested. In any case, it should be noted that the test board lends itself to be produced and put into the market also as a stand alone product (with or without the respective magnetic discs).

Similar considerations apply if the test apparatus has a different architecture or includes similar components. In any case, the test apparatus can receive a different number of test boards (down to a single one), the loader can move the electronic devices and the magnetic discs to and from the test boards already housed in the conditioning zone; moreover, it is possible to provide two independent systems for moving the electronic devices and the magnetic disks.

The proposed solution lends itself to be used in an equivalent test process (by using similar steps, by removing some steps that are not essential, or adding further optional steps - also in a different order).

In alternative, the test board can be produced in a different way. For example, it is possible to use any other material that is deformable and electrically conductive in order to form the receptacles (such as a different epossidic resin), the polymer can be shaped and hardened in a different way (for example, by a moulding technique), or the islands on the pads can be formed with another technique (for example, depositing a layer of polymer and then etching it selectively).

The channels defined around the islands by the restraining stencil can have a different width; moreover, the same result can be achieved with other equivalent means, also intended to remain on the test board (for example, a net, insulating bushings, and the like). In any case, this step can also be completely omitted (such as when the material that is used to form the islands is very viscous, or the islands are sufficiently spaced apart to each other).

The same observations of above apply to the operations required for forming the centring turrets.

## Claims

1. A test system (120, 145; 120', 145') for testing electronic devices (105; 105') each one having a plurality of terminals (115; 115') for electrically contacting the electronic device, wherein the test system includes:
a set of test boards (120; 120'), wherein each test board is equipped with a plurality of banks (127; 127') of electrically conductive receptacles (135; 135') each one for resting a corresponding electronic device, each receptacle being adapted to receive a terminal of the corresponding electronic device, and
locking means (140, 145; 140', 145') for mechanically locking the electronic devices on the test boards,
**characterized in that**
the locking means include interaction means (140) included in each test board and free means (145; 145') adapted to be freely rested on the electronic devices, the interaction means and/or the free means being adapted to generate a magnetic field that generates a magnetic attractive force therebetween for pressing the electronic devices against the test boards.

2. The test system (120, 145; 120', 145') according to claim 1, wherein each test board (120; 120') includes a substrate (125; 125') having a first main surface and a second main surface opposite to each other, the banks of receptacles (127; 127') being formed on the first main surface and the interaction means (140; 140') being fastened on the second main surface.

3. The test system (120, 145; 120', 145') according to claim 1 or 2, wherein at least one of the free means (145; 145') and the interaction means (140; 140') are made of magnetic material.

4. The test system (120, 145; 120', 145') according to claim 3, wherein the interaction means (140; 140') are made of magnetic material and the free means (145; 145') are made of ferromagnetic material.

5. The test system (120, 145; 120', 145') according to any claim from 1 to 4, wherein the interaction means include an interaction element (140; 140') for each bank of receptacles (127; 127').

6. The test system (120, 145; 120', 145') according to claim 5, wherein each interaction element (140; 140') and/or each free element (145; 145') have an extension in cross section substantially equal to an extension of the corresponding bank of receptacles (127; 127').

7. The test system (120, 145) according to any claim from 1 to 6, wherein each terminal (115) ends with a convex contact region, each receptacle (135) including a concave recess matching the convex contact region of the corresponding terminal and being made of an elastic material adapted to elastically deform in response to the pressure of the electronic devices (105) against the test board (120).

8. The test system (120', 145') according to any claim from 1 to 7, wherein each test board (120') further includes centring means (405) for each bank of receptacles (127'), the centring means being adapted to interfere with the corresponding electronic device (105') for aligning each terminal (115') of the electronic device with the corresponding receptacle (135').

9. A test board (120; 120') for use in the test system (120, 145; 120', 145') according to any claim from 1 to 8, the test board including said interaction means (140) being adapted to generate said magnetic field.

10. A test apparatus (200) including the test system (120, 145; 120', 145') according to any claim from 1 to 8, means (225) for picking the electronic devices (105; 105') to be tested from a distribution tray (220) and resting the electronic devices to be tested on the test boards (120; 120'), means (225) for picking the free means (145; 145') from a reservoir (245) and releasing the free means on the electronic devices to be tested being rested on the test boards, means (215) for testing the electronic devices rested on the test boards, means (225) for picking the free means from the test boards and returning the free means to the reservoir, and means (225) for picking the tested electronic devices from the test boards and returning the tested electronic devices to the distribution tray.

11. A process for testing electronic devices (105; 105') each one having a plurality of terminals (115; 115') for electrically contacting the electronic device, wherein the process includes the steps of:
providing a set of test boards (120; 120'), wherein each test board is equipped with a plurality of banks (127; 127') of electrically conductive receptacles (135; 135'),
resting a corresponding electronic device on each bank of receptacles, each receptacle receiving a terminal of the corresponding electronic device, and
locking the electronic devices mechanically on the test boards,
**characterized in that**
the step of locking includes freely resting free means (145; 145') on the electronic devices, interaction means (140) included in each test board and/or the free means generating a magnetic field that generates a magnetic attractive force therebetween for pressing the electronic devices against the test boards.

12. The process according to claim 11, further including the steps of:
picking the electronic devices (105; 105') to be tested from a distribution tray (220) and releasing the electronic devices to be tested on the test boards (120; 120'),
picking the free means (145; 145') from a reservoir (245) and releasing the free means on the electronic devices to be tested being rested on the test boards,
testing the electronic devices locked on the test boards,
picking the free means from the test boards and returning the free means to the reservoir, and
picking the tested electronic devices from the test boards and returning the tested electronic devices to the distribution tray.

13. A production process of the test board (120; 120') according to claim 9, the production process including the steps of:
forming a bank of islands (325;325') for each bank of receptacles (127; 127') on a substrate (125; 125'), the islands being made of an electrically conductive and deformable material,
pressing a forming tool (330;330') including a plurality of forming elements (335;335') corresponding to the terminals (115; 115') of at least one electronic device against the islands for deforming the islands according to the forming elements,
hardening the islands for obtaining the corresponding receptacles (135; 135'), and
fastening the interaction means (140; 140') on the substrate.

14. The process according to claim 13, further including the steps of:
arranging restraining means (345;345') around each island (325;325') for limiting a widening of the islands during the step of pressing the forming tool (330;330').

15. The process according to claim 13 or 14, further including the steps of:
forming at least one column (525) of further deformable material (515) for each bank of receptacles (127') on the first main surface of the substrate, the at least one column being pressed in an inner portion by an edge of a main body of the forming tool (330') corresponding to a case of at least one electronic device (105'), and
hardening the at least one column for obtaining the corresponding centring means (405).

## Patentansprüche

1. Testsystem (120, 145; 120', 145') zum Testen elektronischer Einheiten (105; 105'), von denen jede eine Vielzahl von Anschlüssen (115, 115') zum elektrischen Kontaktieren der elektronischen Einheit besitzt, wobei das Testsystem aufweist:
einen Satz Testplatinen (120; 120'), wobei jede Testplatine mit einer Vielzahl von Bänken (127; 127') aus elektrisch leitenden Aufnahmen (135; 135') ausgestattet ist, von denen jede zum Ablegen einer entsprechenden elektronischen Einheit dient, wobei jede Aufnahme angepasst ist, einen Anschluss der entsprechenden elektronischen Einheit aufzunehmen, und
Verriegelungsmittel (140, 145; 140', 145') zum mechanischen Verriegeln der elektronischen Einheit auf den Testplatinen,
**dadurch gekennzeichnet, dass**
die Verriegelungsmittel aufweisen Interaktionsmittel (140), die in jeder Testplatine enthalten sind, und freie Mittel (145, 145'), die angepasst sind, frei auf den elektronischen Einheiten abgelegt zu werden, wobei die Interaktionsmittel und/oder die freien Mittel angepasst sind, ein magnetisches Feld zu erzeugen, das dazwischen eine magnetische Anziehungskraft zum Drücken der elektronischen Einheit gegen die Testplatinen erzeugt.

2. Testsystem (120, 145; 120', 145') gemäß Anspruch 1, wobei jede Testplatine (120; 120') aufweist einen Träger (125; 125') mit einer ersten Hauptoberfläche und einer zweiten Hauptoberfläche, die zueinander entgegengesetzt sind, wobei die Aufnahmebänke (127; 127') auf der ersten Hauptoberfläche gebildet sind und die Interaktionsmittel (140; 140') auf der zweiten Hauptoberfläche befestigt sind.

3. Testsystem (120, 145; 120', 145') gemäß Anspruch 1 oder 2, wobei wenigstens eines der freien Mittel (145; 145') und die Interaktionsmittel (140; 140') aus einem magnetischen Material sind.

4. Testsystem (120, 145; 120', 145') gemäß Anspruch 3, wobei die Interaktionsmittel (140; 140') aus einem magnetischen Material sind und die freien Mittel (145; 145') aus einem ferromagnetischen Material sind.

5. Testsystem (120, 145; 120', 145') gemäß einem der Ansprüche 1 bis 4, wobei die Interaktionsmittel ein Interaktionselement (140; 140') für jede Aufnahmebank (127; 127') aufweisen.

6. Testsystem (120, 145; 120', 145') gemäß Anspruch 5, wobei jedes Interaktionselement (140; 140') und/oder jedes freie Element (145; 145') eine Verlängerung im Querschnitt aufweist, die im Wesentlichen gleich einer Verlängerung der entsprechenden Aufnahmebank (127; 127') ist.

7. Testsystem (120, 145) gemäß einem der Ansprüche 1 bis 6, wobei jeder Anschluss (115) mit einem konvexen Kontaktbereich endet, wobei jede Aufnahme (145) eine konkave Ausnehmung enthält, die zu dem konvexen Kontaktbereich des entsprechenden Anschlusses passt und aus einem elastischen Material hergestellt ist, welches angepasst ist, in Reaktion auf das Drücken der elektronischen Einheiten (105) gegen die Testplatine (120) sich elastisch zu verformen.

8. Testsystem (120', 145') gemäß einem der Ansprüche 1 bis 7, wobei jede Testplatine (120') weiter aufweist Zentriermittel (405) für jede Aufnahmebank (127'), wobei die Zentriermittel angepasst sind, mit der entsprechenden elektronischen Einheit (105') zum Ausrichten jedes Anschlusses (115') der elektronischen Einheit mit der entsprechenden Aufnahme (135') zusammenzuwirken.

9. Testplatine (120; 120') zur Verwendung in dem Testsystem (120, 145; 120', 145') gemäß einem der Ansprüche 1 bis 8, wobei die Testplatine die Interaktionsmittel (140), die angepasst sind, das magnetische Feld zu erzeugen, aufweist.

10. Testeinrichtung (200) aufweisend das Testsystem (120, 145; 120', 145') gemäß einem der Ansprüche 1 bis 8, Mittel (225) zum Aufnehmen der zu testenden elektronischen Einheiten (105; 105') von einer Verteilungsablage (220) und zum Auflegen der zu testenden elektronischen Einheiten auf den Testplatinen (120; 120'), Mittel (225) zum Aufnehmen der freien Mittel (145; 145') aus einem Reservoir (245) und Abgeben der freien Mittel auf den zu testenden elektronischen Einheiten, die auf den Testplatinen aufgelegt sind, Mittel (215) zum Testen der auf den Testplatinen aufgelegten elektronischen Einheiten, Mittel (225) zum Aufnehmen der freien Mittel von den Testplatinen und Zurückgeben der freien Mittel an das Reservoir und Mittel (225) zum Aufnehmen der getesteten elektronischen Einheiten von den Testplatinen und Zurückgeben der getesteten elektronischen Einheiten auf die Verteilungsablage.

11. Verfahren zum Testen elektronischer Einheiten (105; 105') von denen jede eine Vielzahl von Anschlüssen (115; 115') zum elektrischen Kontaktieren der elektronischen Einheit aufweist, wobei das Verfahren die Schritte aufweist:
Bereitstellen eines Satzes Testplatinen (120; 120'), wobei jede Testplatine mit einer Vielzahl von Bänken (127; 127') elektronisch leitfähiger Aufnahmen (135; 135') ausgerüstet ist,
Auflegen einer entsprechenden elektronischen Einheit auf jeder Aufnahmebank, wobei jede Aufnahme einen Anschluss der entsprechenden elektronischen Einheit aufnimmt, und
Verriegeln der elektronischen Einheiten mechanisch auf den Testplatinen,
**dadurch gekennzeichnet, dass**
der Verriegelschritt aufweist freies Auflegen von freien Mitteln (145; 145') auf die elektronischen Einheiten, wobei Interaktionsmittel (140), die jede Testplatine aufweist, und/oder die freien Mittel ein magnetisches Feld erzeugen, das eine magnetische Anziehungskraft dazwischen zum Drücken der elektronischen Einheiten gegen die Testplatinen erzeugt.

12. Verfahren gemäß Anspruch 11, weiter aufweisend die Schritte:
Aufnehmen der zu testenden elektronischen Einheiten (105; 105') von einer Verteilungsablage (220) und Abgeben der zu testenden elektronischen Einheiten auf den Testplatinen (120; 120'),
Aufnehmen der freien Mittel (145; 145') von einem Reservoir (245) und Abgeben der freien Mittel auf den zu testenden elektronischen Einheiten, die auf den Testplatinen abgelegt sind,
Testen der elektronischen Einheiten, die auf den Testplatinen verriegelt sind,
Aufnehmen der freien Mittel von den Testplatinen und Zurückgeben der freien Mittel an das Reservoir, und
Aufnehmen der getesteten elektronischen Einheiten von den Testplatinen und Zurückgeben der getesteten elektronischen Einheiten an die Verteilungsablage.

13. Produktionsprozess der Testplatine (120; 120') gemäß Anspruch 9, wobei der Produktionsprozess die Schritte aufweist:
Bilden einer Bank von Inseln (325; 325') für jede Aufnahmebank (127; 127') auf einem Träger (125; 125'), wobei die Inseln aus einem elektrisch leitfähigen und verformbaren Material hergestellt sind,
Drücken eines Formgebungswerkzeugs (330; 330'), welches eine Vielzahl von formgebenden Elementen (335; 335') aufweist, die den Anschlüssen (115; 115') von wenigstens einer elektronischen Einheit entspricht, gegen die Inseln zum Verformen der Inseln entsprechend den formgebenden Elementen,
Aushärten der Inseln zum Erhalten der entsprechenden Aufnahmen (135; 135'), und
Befestigen der Interaktionsmittel (140; 140') auf dem Träger.

14. Prozess gemäß Anspruch 13, weiter aufweisend die Schritte:
Anordnen von Rückhaltemitteln (345; 345') um jede Insel (325; 325') zum Beschränken einer Aufweitung der Inseln während des Drückschritts des formgebenden Werkzeugs (330; 330').

15. Prozess gemäß Anspruch 13 oder 14, weiter aufweisend die Schritte:
Bilden wenigstens eines Ständers (525) aus einem weiteren verformbaren Material (515) für jede Aufnahmebank (127') auf der ersten Hauptoberfläche des Trägers, wobei der wenigstens eine Ständer in einem inneren Abschnitt durch eine Kante eines Hauptkörpers des Formgebungswerkzeugs (330') entsprechend einem Gehäuse von wenigstens einer elektronischen Einheit (105') gedrückt wird, und
Aushärten des wenigstens einen Ständers zum Erhalten der entsprechenden Zentriermittel (405).

## Revendications

1. Système de test (120, 145 ; 120', 145') pour tester des dispositifs électroniques (105 ; 105') ayant chacun une pluralité de bornes (115 ; 115') pour contacter électriquement le dispositif électronique, le système de test comprenant :
un ensemble de cartes de test (120 ; 120'), dans lequel chaque carte de test est équipée d'une pluralité de batteries (127 ; 127') de réceptacles conducteurs électriques (135 ; 135'), chacune étant destinée à supporter un dispositif électronique correspondant, chaque réceptacle étant adapté à recevoir une borne du dispositif électronique correspondant, et
des moyens de verrouillage (140, 145 ; 140', 145') pour verrouiller mécaniquement les dispositifs électroniques sur les cartes de test,
**caractérisé en ce que**
les moyens de verrouillage comprennent des moyens d'interaction (140) inclus dans chaque carte de test et des moyens libres (145 ; 145') adaptés à être déposés sur les dispositifs électroniques, les moyens d'interaction et/ou les moyens libres étant adaptés à générer un champ magnétique qui produit une force d'attraction magnétique entre eux pour presser les dispositifs électroniques contre les cartes de test.

2. Système de test (120, 145 ; 120', 145') selon la revendication 1, dans lequel chaque carte de test (120 ; 120') comprend un substrat (125 ; 125') ayant une première surface principale et une deuxième surface principale face à face, les batteries de réceptacles (127 ; 127') étant formées sur la première surface principale et les moyens d'interaction (140 ; 140') étant fixés sur la deuxième surface principale.

3. Système de test (120, 145 ; 120', 145') selon la revendication 1 ou 2, dans lequel au moins l'un des moyens libres (145 ; 145') et des moyens d'interaction (140 ; 140') est en un matériau magnétique.

4. Système de test (120, 145 ; 120', 145') selon la revendication 3, dans lequel les moyens d'interaction (140 ; 140') sont en un matériau magnétique et les moyens libres (145 ; 145') sont en un matériau ferromagnétique.

5. Système de test (120, 145 ; 120', 145') selon l'une quelconque des revendications 1 à 4, dans lequel les moyens d'interaction comprennent un élément d'interaction (140 ; 140') pour chaque batterie de réceptacles (127 ; 127').

6. Système de test (120, 145 ; 120', 145') selon la revendication 5, dans lequel chaque élément d'interaction (140 ; 140') et/ou chaque élément libre (145 ; 145') comporte une extension en coupe transversale sensiblement identique à une extension de la batterie de réceptacles (127 ; 127') correspondante.

7. Système de test (120, 145) selon l'une quelconque des revendications 1 à 6, dans lequel chaque borne (115) se termine par une région de contact convexe, chaque réceptacle (135) comprenant une partie en creux concave concordant avec la région de contact convexe de la borne correspondante et faite d'un matériau élastique adapté à se déformer de façon élastique en réponse à la pression des dispositifs électroniques (105) contre la carte de test (120).

8. Système de test (120', 145') selon l'une quelconque des revendications 1 à 7, dans lequel chaque carte de test (120') comprend en outre des moyens de centrage (405) pour chaque batterie de réceptacles (127'), les moyens de centrage étant adaptés à interférer avec le dispositif électronique (105') correspondant pour aligner chaque borne (115') du dispositif électronique avec le réceptacle (135') correspondant.

9. Carte de test (120 ; 120') pour utilisation dans le système de test (120, 145 ; 120', 145') selon l'une quelconque des revendications 1 à 8, la carte de test comprenant lesdits moyens d'interaction (140) étant adaptée à générer le champ magnétique.

10. Appareil de test (200) comprenant le système de test (120, 145 ; 120', 145') selon l'une quelconque des revendications 1 à 8, des moyens (225) pour prendre les dispositifs électroniques (105 ; 105') à tester sur un plateau de distribution (220) et déposer les dispositifs électroniques à tester sur les cartes de test (120 ; 120'), des moyens (225) pour prendre les moyens libres (145 ; 145') dans un réservoir (245) et libérer les moyens libres sur les dispositifs électroniques à tester qui reposent sur les cartes de test, des moyens (215) pour tester les dispositifs électroniques qui reposent sur les cartes de test, des moyens (225) pour prendre les moyens libres sur les cartes de test et renvoyer les moyens libres vers le réservoir, et des moyens (225) pour prendre les dispositifs électroniques testés sur les cartes de test et renvoyer les dispositifs électroniques testés vers le plateau de distribution.

11. Procédé pour tester des dispositifs électroniques (105 ; 105') ayant chacun une pluralité de bornes (115 ; 115') pour contacter électriquement le dispositif électronique, le procédé comprenant les étapes suivantes :
prévoir un ensemble de cartes de test (120 ; 120'), chaque carte de test étant équipée d'une pluralité de batteries (127 ; 127') de réceptacles conducteurs électriques (135 ; 135') ;
déposer un dispositif électronique correspondant sur chaque batterie de réceptacles, chaque réceptacle recevant une borne du dispositif électronique correspondant ; et
verrouiller mécaniquement les dispositifs électroniques sur les cartes de test,
**caractérisé en ce que**
l'étape de verrouillage comprend la dépose libre de moyens libres (145 ; 145') sur les dispositifs électroniques, des moyens d'interaction (140) inclus dans chaque carte de test et/ou les moyens libres générant un champ magnétique qui génère ou produit une force d'attraction magnétique entre eux pour presser les dispositifs électroniques contre les cartes de test.

12. Procédé selon la revendication 11, comprenant en outre les étapes suivantes :
prendre les dispositifs électroniques (105 ; 105') à tester sur un plateau de distribution (220) et libérer les dispositifs électroniques à tester sur les cartes de test (120 ; 120') ;
prendre les moyens libres (145 ; 145') dans un réservoir (245) et libérer les moyens libres sur les dispositifs électroniques à tester qui reposent sur les cartes de test,
tester les dispositifs électroniques verrouillés sur les cartes de test,
prendre les moyens libres sur les cartes de test et renvoyer les moyens libres vers le réservoir, et
prendre les dispositifs électroniques testés sur les cartes de test et renvoyer les dispositifs électroniques testés vers le plateau de distribution.

13. Procédé de fabrication de la carte de test (120 ; 120') selon la revendication 9, le procédé de fabrication comprenant les étapes suivantes :
former une batterie d'îlots (325 ; 325') pour chaque batterie de réceptacles (127 ; 127') sur un substrat (125 ; 125'), les îlots étant faits d'un matériau conducteur électrique et déformable,
presser un outil de mise en forme (330 ; 330'), comprenant une pluralité d'éléments de mise en forme (335 ; 335') correspondant aux bornes (115 ; 115') d'au moins un dispositif électronique, contre les îlots pour déformer les îlots conformément aux éléments de mise en forme,
durcir les îlots pour obtenir les réceptacles (135 ; 135') correspondants, et
fixer les moyens d'interaction (140 ; 140') sur le substrat.

14. Procédé selon la revendication 13, comprenant en outre l'étape suivante :
agencer des moyens de contrainte (345 ; 345') autour de chaque îlot (325 ; 325') pour limiter l'élargissement des îlots pendant l'étape de pression de l'outil de mise en forme (330 ; 330').

15. Procédé selon les revendications 13 ou 14, comprenant en outre l'étape suivante :
former au moins une colonne (525) d'un autre matériau déformable (515) pour chaque batterie de réceptacles (127') sur la première surface principale du substrat, ladite au moins une colonne étant pressée dans une partie intérieure par un bord du corps principal de l'outil de mise en forme (330') correspondant au cas d'au moins un dispositif électronique (105'), et
durcir ladite au moins une colonne pour obtenir les moyens de centrage (405) correspondants.
